# EUROPEAN PATENT APPLICATION

(11) **EP 4 697 047 A1**
(43) Date of publication of application: **18.02.2026**
(21) Application number: 25191794.4
(22) Date of filing: 25.07.2025
(51) Int. Cl.: G01R 31/69

(54) **CONNECTOR DETECTION DEVICE AND CONNECTOR-RELATED SIGNAL DETECTION METHOD**

(30) Priority: 15.08.2024 TW 113130774
(71) Applicant: Arcadyan Technology Corporation, Hsinchu City 30071 (TW)
(72) Inventor: Chang, Chia-Sheng, 3007 Hsinchu City (TW); Liou, Yu-Fan, 30071 Hsinchu City (TW)
(74) Representative: Stevens Hewlett & Perkins

(57) **Abstract**

A connector detection device includes a shell, a circuit device, a pin module and a metal sheet. The circuit device includes a ground circuit and a high voltage circuit, the ground circuit provides a low voltage level, and the high voltage circuit provides a high voltage level. The pin module includes a first detection pin, coupled to the ground circuit, and a second detection pin, coupled to the high-voltage circuit. When the metal sheet contacts the first and the second detection pins, a short circuit is formed, so that both the first and the second detection pins are at a low voltage level. When the metal sheet is separated from the first and the second detection pins, an open circuit is formed, so that the first detection pin is at a low voltage level and the second detection pin is at a high voltage level.

## Description

### BACKGROUND OF THE INVENTION

### 1. Field of the Invention

The present invention relates generally to a detection device and a detection method, and more particularly, relates to a connector detection device and a connector-related signal detection method.

### 2. The Prior Arts

A connector (commonly known as a crystal plug) can be inserted into an Ethernet connector and is used to connect an Internet-enabled device to another network device, for example, the connection between a computer and a server, a router, a modem, a smart TV, a game console, or any other device that utilizes the Ethernet protocol.

However, the general Ethernet connectors cannot detect whether the connector is fully inserted.

### SUMMARY OF THE INVENTION

A primary objective of the present invention is to provide a connector detection device and related signal detection method, which can accurately detect whether the connector is fully inserted.

In order to achieve the aforementioned objective, the present invention provides a connector detection device, which includes a shell, a circuit device, a pin module and a metal sheet; the circuit device includes a ground circuit providing a low voltage level and a high voltage circuit providing a high voltage level; the pin module is disposed in the shell, the pin module includes a first detection pin and a second detection pin, the first detection pin is coupled to the ground circuit, and the second detection pin is coupled to the high voltage circuit; the metal sheet is disposed in the shell; wherein, when the metal sheet contacts the first detection pin and the second detection pin, the metal sheet, the first detection pin, and the second detection pin form a short circuit, so that the first detection pin and the second detection pin are both at a low voltage level; wherein, when the metal sheet is separated from the first detection pin and the second detection pin, the metal sheet, the first detection pin, and the second detection pin form an open circuit, so that the first detection pin is at a low voltage level and the second detection pin is at a high voltage level.

In some embodiments, the shell has a positioning part, the metal sheet includes a fixing part and a plurality of arm parts, the fixing part is fixed on the positioning part, and the plurality of arm parts are respectively arranged on both sides of the fixing parts; wherein, when the metal sheet contacts the first detection pin and the second detection pin, the plurality of arm parts contact the first detection pin and the second detection pin respectively.

In some embodiments, each of the plurality of arm parts has a bending part; wherein, when the metal sheet contacts the first detection pin and the second detection pin, the plurality of bending parts is used to contact the first detection pin and the second detection pin.

In some embodiments, the positioning part has a groove, the fixing part includes a fixing plate and an abutting plate, the fixing plate is disposed in the groove, and the abutting plate abuts against an outer lateral wall of the positioning part.

In some embodiments, the pin module further includes a plurality of signal transmission pins located between the first detection pin and the second detection pin; wherein, the first detection pin includes a contact part, the contact part of the first detection pin has a first protruding part, the second detection pin includes a contact part, and the contact part of the second detection pin has a second protruding part, each of the plurality of signal transmission pins includes a straight part, and the straight parts of the plurality of signal transmission pins are between the contact part of the first detection pin and the contact part of second detection pin.

In some embodiments, the lengths of the contact part of the first detection pin and the contact part of the second detection pin are greater than the length of a straight part of each of the plurality of signal transmission pins.

In order to achieve the aforementioned objective, the present invention provides a connector-related signal detection method, which includes the following steps: (a) a ground circuit of a circuit device of a connector detection device provides a low voltage level, a high voltage circuit of the circuit device provides a high voltage level, a first detection pin of a pin module of the connector detection device is coupled to the ground circuit, and a second detection pin of the pin module is coupled to the high voltage circuit; (b) when a connector has not been inserted into a shell of the connector detection device, a metal sheet of the connector detection device contacts the first detection pin and the second detection pin, the metal sheet, the first detection pin, and the second detection pin form a short circuit, so that the first detection pin and the second detection pin are both at a low voltage level, and a processing unit determines that the connector has not been inserted into the shell based on both the first detection pin and the second detection pin being at a low voltage level; and (c) when the connector is inserted into the shell, the connector presses the first detection pin and the second detection pin, and the metal sheet is separated from the first detection pin and the second detection pin, the metal sheet, the first detection pin, and the second detection pin form an open circuit, so that the first detection pin is at a low voltage level and the second detection pin is at a high voltage level, and the processing unit determines that the connector has been inserted into the shell based on the first detection pin being at a low voltage level and the second detection pin being at a high voltage level.

In some embodiments, step (b) further includes: a plurality of arm parts of the metal sheet contact the first detection pin and the second detection pin respectively; wherein step (c) further includes: the plurality of arm parts are respectively away from the first detection pin and the second detection pin.

In some embodiments, step (b) further includes: a bending part of each the plurality of arm parts respectively contacts the first detection pin and the second detection pin; wherein step (c) further includes: the bending part of each of the plurality of arm parts is respectively away from the first detection pin and the second detection pin.

In some embodiments, step (c) further includes: the connector presses a first protruding part of the first detection pin and a second protruding part of the second detection pin.

The effect of the present invention is that the present invention can accurately detect whether the connector is fully inserted through the structural configuration of the first detection pin, the second detection pin, and the metal sheet.

### BRIEF DESCRIPTION OF THE DRAWINGS

The present invention will be apparent to those skilled in the art by reading the following detailed description of a preferred embodiment thereof, with reference to the attached drawings, in which:
FIG. 1 is a perspective view of the connector detection device of the present invention.
FIG. 2 is an exploded view of the connector detection device of the present invention.
FIG. 3 is a schematic view of the circuit device of the present invention.
FIG. 4 is a perspective view of the pin module of the present invention.
FIG. 5 is a perspective view of the metal sheet of the present invention.
FIG. 6 is a front view of the connector detection device of the present invention.
FIG. 7 is a rear view of the connector detection device of the present invention.
FIG. 8 is a cross-sectional view along line VIII-VIII in FIG. 1.
FIG. 9 is a cross-sectional view along line IX-IX in FIG. 1.
FIG. 10 is a cross-sectional view along line X-X in FIG. 1.
FIG. 11 is a flow chart of the method of the present invention.
FIG. 12 is a schematic view of the connection relationship between the second pin, the seventh pin, and the processing unit of the present invention.
FIGS. 13 and 14 are schematic views of step S20 of the method of the present invention.
FIGS. 15 and 16 are schematic views of step S30 of the method of the present invention.

### DETAILED DESCRIPTION OF THE PREFERRED EMBODIMENT

The accompanying drawings are included to provide a further understanding of the invention, and are incorporated in and constitute a part of this specification. The drawings illustrate embodiments of the invention and, together with the description, serve to explain the principles of the invention.

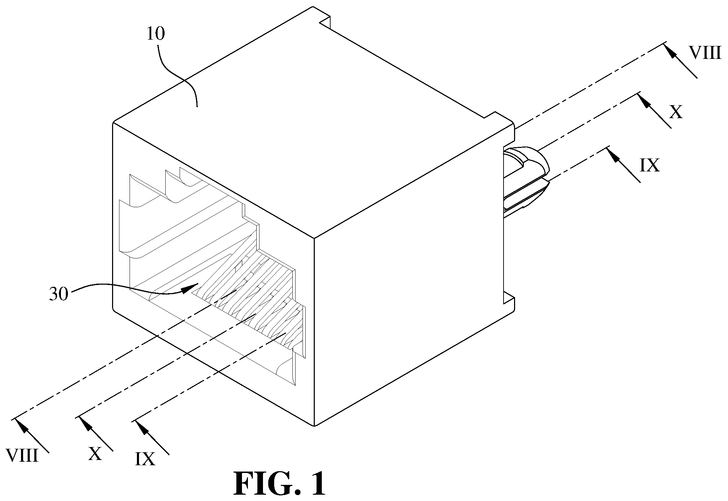

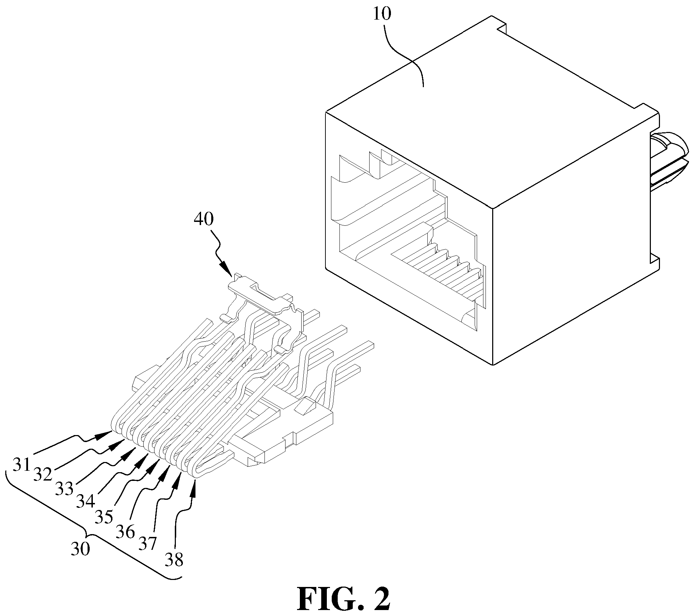

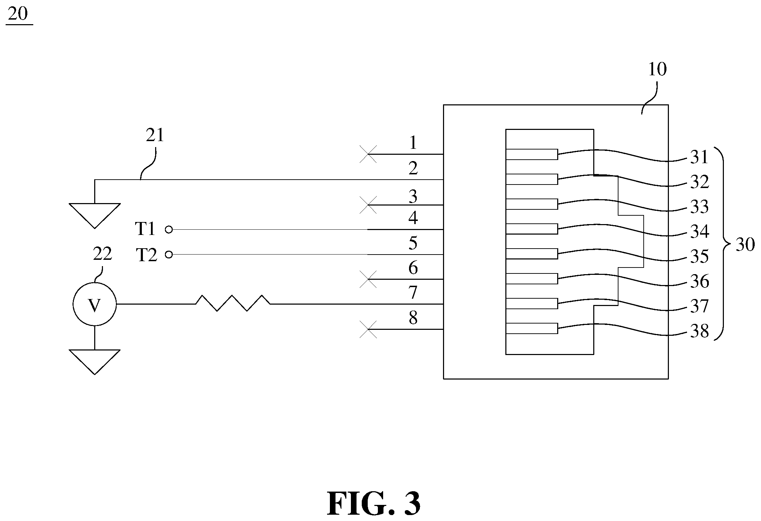

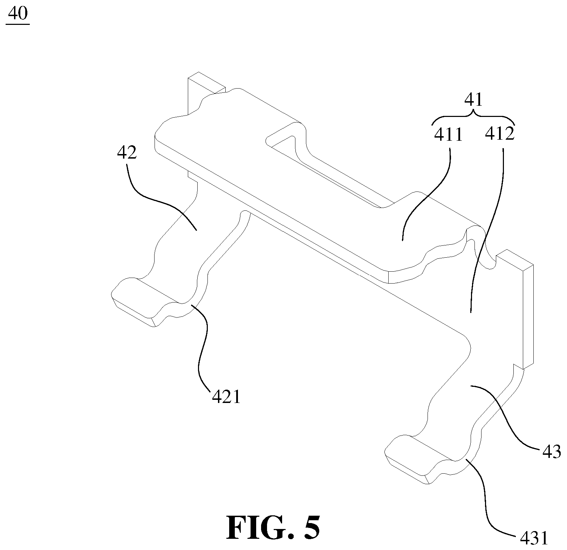

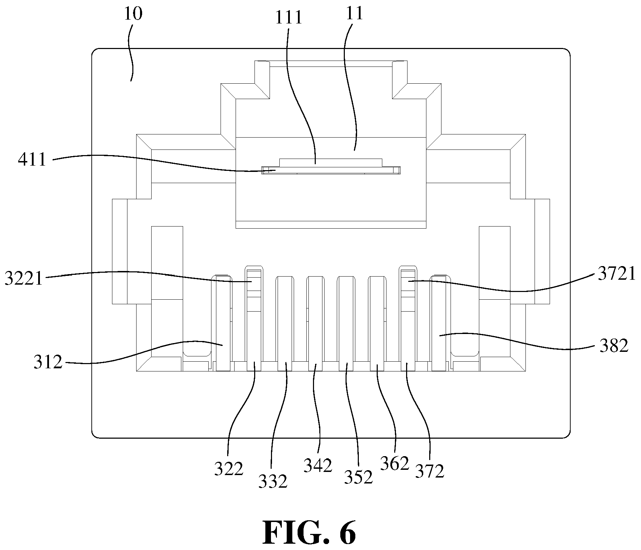

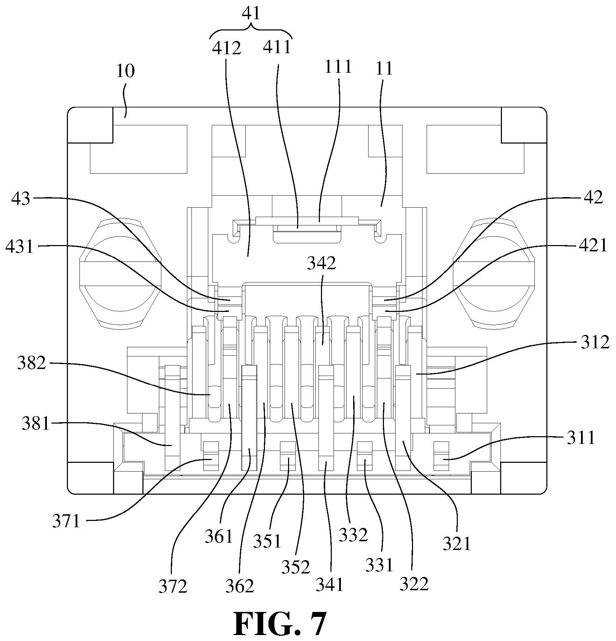

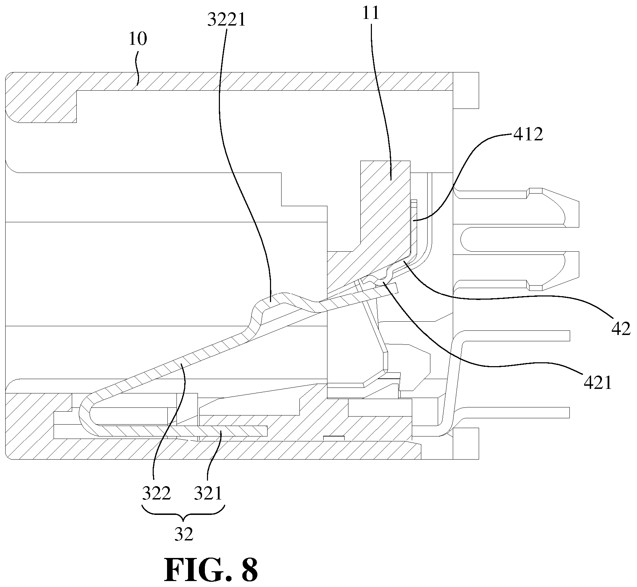

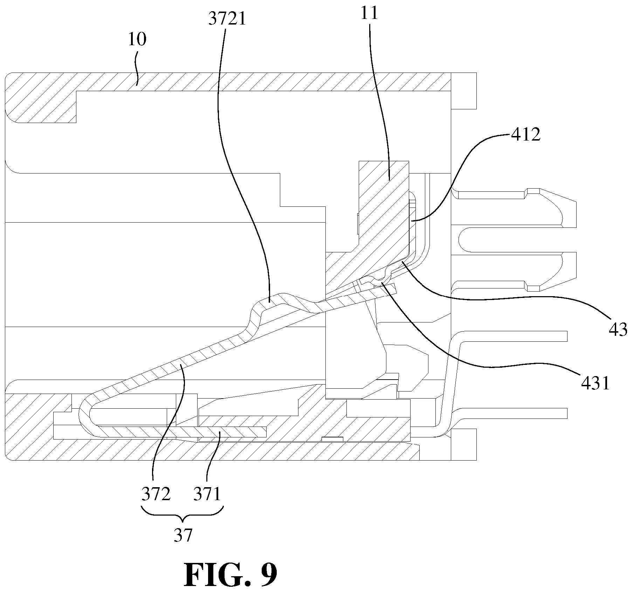

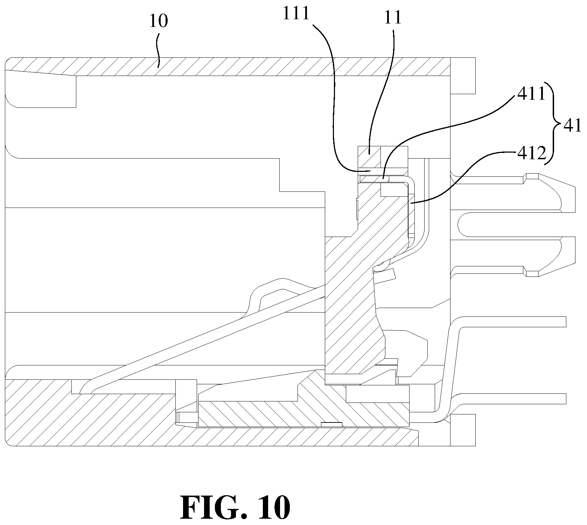

FIG. 1 is a perspective view of the connector detection device of the present invention; FIG. 2 is an exploded view of the connector detection device of the present invention; FIG. 3 is a schematic view of the circuit device of the present invention; FFIG. 4 is a perspective view of the pin module of the present invention; FIG. 5 is a perspective view of the metal sheet of the present invention; FIG. 6 is a front view of the connector detection device of the present invention; FIG. 7 is a rear view of the connector detection device of the present invention; FIG. 8 is a cross-sectional view along line VIII-VIII in FIG. 1; FIG. 9 is a cross-sectional view along line IX-IX in FIG. 1; and FIG. 10 is a cross-sectional view along line X-X in FIG. 1. As shown in FIGS. 1 to 3, the present invention provides a connector detection device, including a shell 10, a circuit device 20, a pin module 30, and a metal sheet 40.

As shown in FIGS. 6 and 7, the shell 10 has a positioning part 11, and the positioning part 11 has a groove 111.

As shown in FIGS. 1, 6 and 7, the pin module 30 is disposed in the shell 10. As shown in FIGS. 2, 3, 4, 6 and 7, the pin module 30 includes a first pin 31, a second pin 32, a third pin 33, and a fourth pin 34, a fifth pin 35, a sixth pin 36, a seventh pin 37, and an eighth pin 38, in a sequence. As shown in FIG. 3, the connector detection device has a first terminal 1 electrically connected to the first pin 31, a second terminal 2 electrically connected to the second pin 32, a third terminal 3 electrically connected to the third pin 33, a fourth terminal 4 electrically connected to the fourth pin 34, a fifth terminal 5 electrically connected to the fifth pin 35, a sixth terminal 6 electrically connected to the sixth pin 36, a seventh terminal 7 electrically connected to the seventh pin 37, and an eighth terminal 8 electrically connected to the eighth pin 38. The circuit device 20 includes a ground circuit 21 and a high voltage circuit 22. The ground circuit 21 provides a low voltage level, and the high voltage circuit 22 provides a high voltage level.

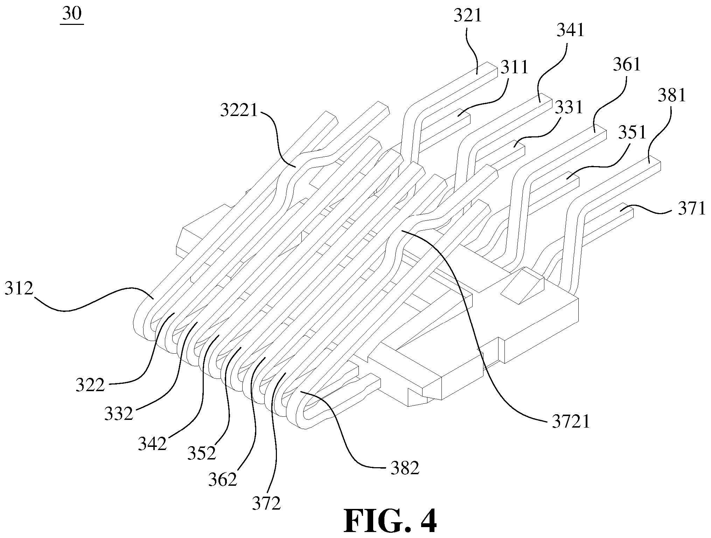

In one embodiment, the first pin 31, the third pin 33, the sixth pin 36 and the eighth pin 38 can be assigned no function, the second pin 32 is defined as a first detection pin and is coupled to the ground circuit 21 through the second terminal 2, the seventh pin 37 is defined as a second detection pin and is coupled to the high voltage circuit 22 through the seventh terminal 7, the fourth pin 34 and the fifth pin 35 are defined as signal transmission pins, which receives signals T1 and T2 through the fourth terminal 4 and the fifth terminal. More specifically, as shown in FIGS. 2, 4, 6 and 7, the first pin 31 has a fixed end 311 and a straight part 312, the second pin 32 has a fixed end 321 and a contact part 322, the third pin 33 has a fixed end 331 and a straight part 332, the fourth pin 34 has a fixed end 341 and a straight part 342, the fifth pin 35 has a fixed end 351 and a straight part 352, the sixth pin 36 has a fixed end 361 and a straight part 362, the seventh pin 37 has a fixed end 371 and a contact part 372, and the eighth pin 38 has a fixed end 381 and a straight part 382. The fixed end 311 of the first pin 31, the fixed end 321 of the second pin 32, the fixed end 331 of the third pin 33, the fixed end 341 of the fourth pin 34, the fixed end 351 of the fifth pin 35, the fixed end 361 of the sixth pin 36, the fixed end 371 of the seventh pin 37, and the fixed end 381 of the eighth pin 38 are all fixed on the bottom of the shell 10 to fix the positions of the first pin 31 and, the second pin 32, the third pin 33, the fourth pin 34, the fifth pin 35, the sixth pin 36, the seventh pin 37, and the eighth pin 38. The fixed end 311 of the first pin 31 is connected to the straight part 312 of the first pin 31 and forms an angle. The fixed end 321 of the second pin 32 is connected to the contact part 322 of the second pin 32 and forms an angle. The fixed end 331 of the pin 33 is connected to the straight part 332 of the third pin 33 and forms an angle. The fixed end 341 of the fourth pin 34 is connected to the straight part 342 of the fourth pin 34 and forms an angle. The fixed end 351 of the fifth pin 35 is connected to the straight part 352 of the fifth pin 35 and forms an angle. The fixed end 361 of the sixth pin 36 is connected to the straight part 362 of the sixth pin 36 and forms an angle. The fixed end 371 of the seventh pin 37 is connected to the contact part 372 of the seventh pin 37 and forms an angle. The fixed end 381 of the eighth pin 38 is connected to the straight part 382 of the eighth pin 38 and forms an angle. In other words, the first pin 31, the second pin 32, the third pin 33, the fourth pin 34, the fifth pin 35, the sixth pin 36, the seventh pin 37, and the eighth pin 38 are all bent. In one embodiment, the straight part 312 of the first pin 31, the contact part 322 of the second pin 32, the straight part 332 of the third pin 33, and the straight part 342 of the fourth pin 34, the straight part 352 of the fifth pin 35, the straight part 362 of the sixth pin 36, the contact part 372 of the seventh pin 37, and the straight part 382 of the eighth pin 38 are all made of elastic metals. The fixed end 311 of the first pin 31 is located outside the fixed end 321 of the second pin 32, the straight part 312 of the first pin 31 is located outside the contact part 322 of the second pin 32, the fixed end 381 of the eighth pin 38 is located outside the fixed end 371 of the seventh pin 37, the straight part 382 of the eighth pin 38 is located outside the contact part 372 of the seventh pin 37, and the fixed end 331 of the third pin 33, the fixed end 341 of the fourth pin 34, the fixed end 351 of the fifth pin 35, and the fixed end 361 of the sixth pin 36 are located between the fixed end 321 of the second pin 32 and the fixed end 371 of the seventh pin 37. As shown in FIGS. 4, 6, 8, and 9, the contact part 322 of the second pin 32 includes a first protruding part 3221, the contact part 372 of the seventh pin 37 includes a second protruding part 3721, and the straight part 332 of the third pin 33, the straight part 342 of the fourth pin 34, the straight part 352 of the fifth pin 35, and the straight part 362 of the sixth pin 36 are located between the contact part 322 of the second pin 32 and the contact part 372 of the seventh pin 37. Preferably, the lengths of the contact part 322 of the second pin 32 and the contact part 372 of the seventh pin 37 are greater than the lengths of the straight part 342 of the fourth pin 34 and the straight part 352 of the fifth pin 35.

As shown in FIGS. 2, 5, 6, and 7, the metal sheet 40 includes a fixing part 41 and a plurality of arm parts 42, 43. The fixing part 41 includes a fixing plate 411 and an abutting plate 412. The fixing plate 411 is disposed in the groove 111, and the abutting plate 412 abuts against the outer wall of the positioning part 11. The plurality of arm parts 42 and 43 are provided on both sides of the abutting plate 412, and each arm part 42, 43 has a bending part 421, 431.

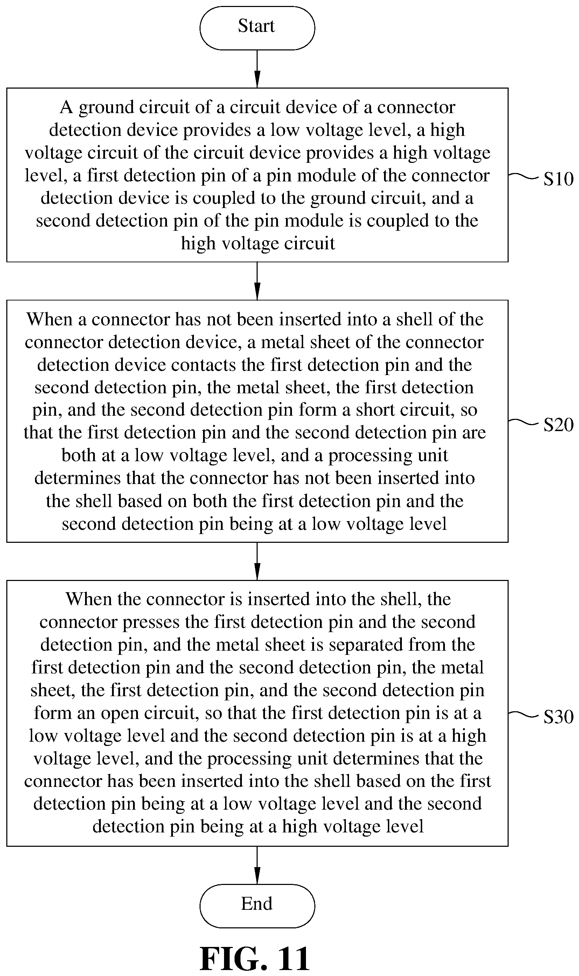

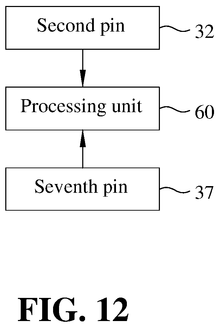

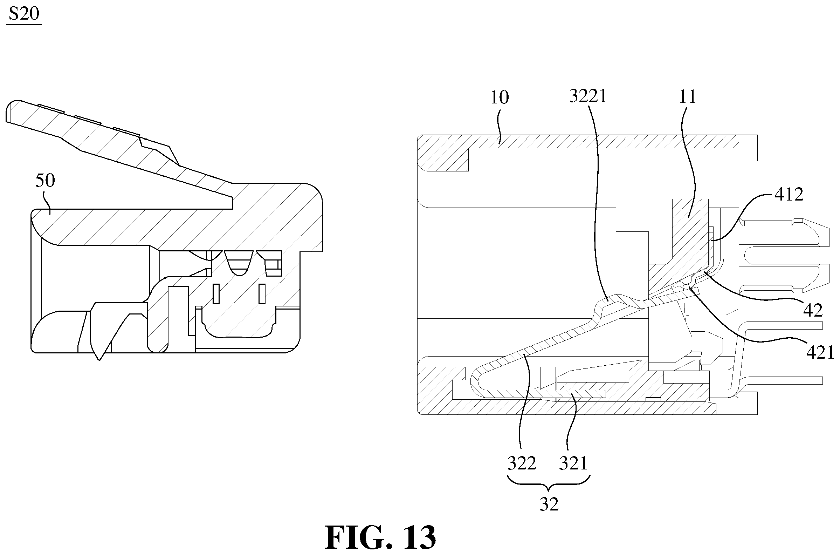

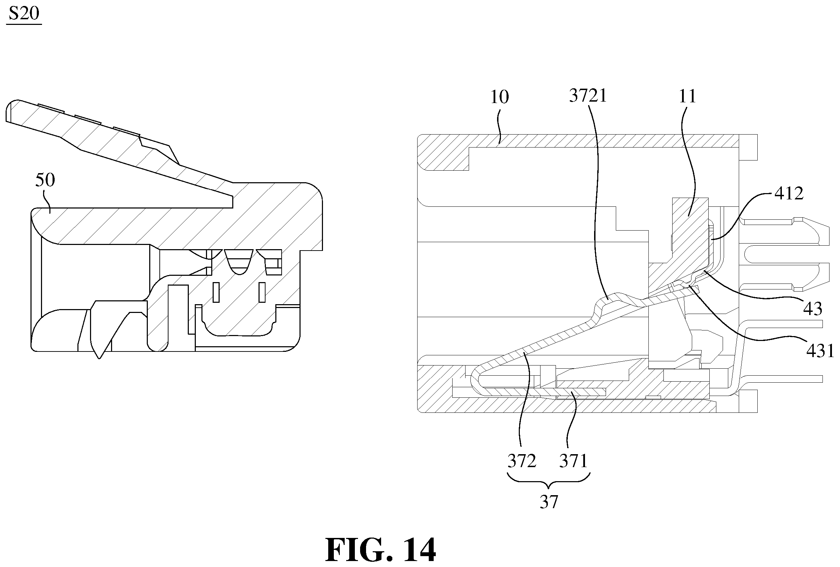

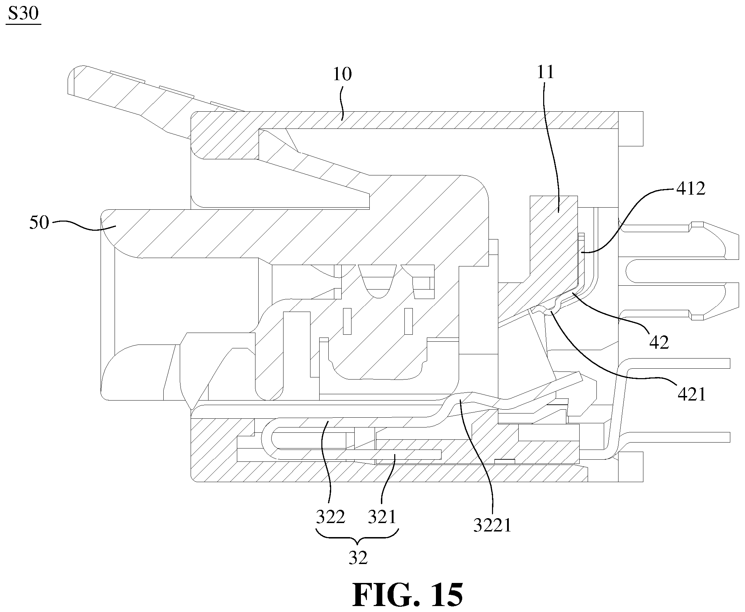

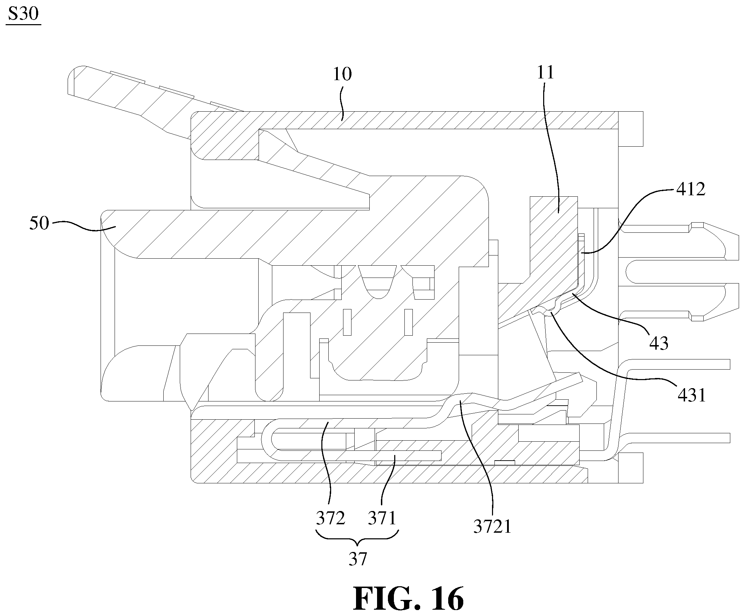

FIG. 11 is a flow chart of the method of the present invention; FIG. 12 is a schematic view of the connection relationship between the second pin, the seventh pin, and the processing unit of the present invention; FIGS. 13 and 14 are schematic views of step S20 of the method of the present invention; and, FIGS. 15 and 16 are schematic views of step S30 of the method of the present invention. The present invention provides a connector-related signal detection method, which includes the following steps:

Step S10, as shown in FIGS. 2 and 11, the ground circuit 21 provides a low voltage level, the high voltage circuit 22 provides a high voltage level, and the second pin 32 is coupled to the ground circuit 21 through the second terminal 2, and the seventh pin 37 is coupled to the high voltage circuit 22 through the seventh terminal 7.

Step S20, as shown in FIGS. 11, 12, 13, and 14, when a connector 50 has not yet been inserted into the shell 10, the bottoms of the bending parts 421 and 431 of the plurality of arm parts 42 and 43 respectively contact one end of the contact part 322 of the second pin 32 and one end of the contact part 372 of the seventh pin 37. As such, the metal sheet 40, the second pin 32, and the seventh pin 37 form a short circuit, so that the second pin 32 and the seventh pin 37 are both at a low voltage level, and a processing unit 60 determines that the connector 50 has not been inserted into the shell 10 based on both the second pin 32 and the seventh pin 37 bring at a low voltage level.

Step S30, as shown in FIGS. 11, 12, 15, and 16, when the connector 50 is inserted into the shell 10, the connector 50 presses the first protruding part 3221 of the second pin 32 and the second protruding part 3721 of the seventh pin 37 and the bottoms of the bending parts 421 and 431 of the plurality of arm parts 42 and 43 are respectively separated from one end of the second pin 32 and one end of the seventh pin 37. As such, the metal sheet 40, the second pin 32, and the seventh pin 37 form an open circuit, so that the second pin 32 is at a low voltage level and the seventh pin 37 is at a high voltage level. The processing unit 60 determines that the connector 50 has been inserted into the shell 10 based on the second pin. 32 being at the low voltage level and the seventh pin 37 is at the high voltage level.

In summary, the present invention can use the structure of the first detection pin (i.e., the second pin 32), the second detection pin (i.e., the seventh pin 37) and the metal sheet 40 to accurately detects whether the connector 50 is fully inserted.

Furthermore, the fixing plate 411 and the abutting plate 412 of the fixing part 41 of the metal sheet 40 can improve the fixing effect of the metal sheet 40, so that the bending parts 421 and 431 of the plurality of arm parts 42 and 43 of the metal sheet 40 can precisely contact the first detection pin (i.e., the second pin 32) and the second detection pin (i.e., the seventh pin 37) to form a short circuit.

Moreover, because the length of the contact part 322 of the first detection pin (i.e., the second pin 32) and the contact part 372 of the second detection pin (i.e., the seventh pin 37) is longer than the length of the straight parts 342 and 352 of the plurality of signal transmission pins (i.e., the fourth pin 34 and the fifth pin 35), so the plurality of arm parts 42 and 43 of the metal sheet 40 are in contact with the first detection pin and the second detection pin. The contact position of the detection pin will not fall between the plurality of signal transmission pins, so as to avoid the risk of accidental contact between the plurality of arm parts 42 and 43 of the metal sheet 40 and the plurality of signal transmission pins.

In addition, the connector 50 will only press the first protruding part 3221 of the first detection pin (i.e., the second pin 32) and the second protruding part 3721 of the second detection pin (i.e., the seventh pin 37), but will not press the straight parts 342 and 352 of the plurality of signal transmission pins (i.e., the fourth pin 34 and the fifth pin 35), which improves the present invention's ability to precisely detect whether the connector 50 is fully inserted.

Although the present invention has been described with reference to the preferred embodiments thereof, it is apparent to those skilled in the art that a variety of modifications and changes may be made without departing from the scope of the present invention which is intended to be defined by the appended claims.

## Claims

1. A connector detection device, comprising:
a shell;
a circuit device, comprising a ground circuit providing a low voltage level and a high voltage circuit providing a high voltage level;
a pin module, disposed in the shell and comprising a first detection pin and a second detection pin, wherein the first detection pin is coupled to the ground circuit, and the second detection pin is coupled to the high voltage circuit; and
a metal sheet, disposed in the shell,
wherein, when the metal sheet contacts the first detection pin and the second detection pin, the metal sheet, the first detection pin, and the second detection pin form a short circuit, so that the first detection pin and the second detection pin are both at the low voltage level; and
wherein, when the metal sheet is separated from the first detection pin and the second detection pin, the metal sheet, the first detection pin, and the second detection pin form an open circuit, so that the first detection pin is at the low voltage level and the second detection pin is at the high voltage level.

2. The connector detection device according to claim 1, wherein the shell has a positioning part, the metal sheet includes a fixing part, a first arm part and a second arm part, the fixing part is fixed on the positioning part, and the first and the second arm parts are respectively arranged on both sides of the fixing parts; wherein, when the metal sheet contacts the first detection pin and the second detection pin, the first and the second arm parts contact the first detection pin and the second detection pin respectively.

3. The connector detection device according to claim 2, wherein each of the first and the second arm parts has a bending part; wherein, when the metal sheet contacts the first detection pin and the second detection pin, the bending parts are used to contact the first detection pin and the second detection pin.

4. The connector detection device according to claim 2, wherein the positioning part has a groove, the fixing part includes a fixing plate and an abutting plate, the fixing plate is disposed in the groove, and the abutting plate abuts against an outer lateral wall of the positioning part.

5. The connector detection device according to claim 1, wherein the pin module further comprises a plurality of signal transmission pins located between the first detection pin and the second detection pin, wherein, the first detection pin includes a contact part, the contact part of the first detection pin has a first protruding part, the second detection pin includes a contact part, and the contact part of the second detection pin has a second protruding part, each of the plurality of signal transmission pins includes a straight part, and the straight parts of the plurality of signal transmission pins are between the contact part of the first detection pin and the contact part of second detection pin.

6. The connector detection device according to claim 5, wherein a first length of the contact part of the first detection pin and a second length of the contact part of the second detection pin are greater than a length of the straight part of each of the plurality of signal transmission pins.

7. A connector-related signal detection method, comprising the following steps:
(a) providing a processing unit, a connector and a connector detection device, wherein the connector detection device comprises:
a shell;
a circuit device, comprising a ground circuit providing a low voltage level and a high voltage circuit providing a high voltage level;
a pin module, disposed in the shell and comprising a first detection pin and a second detection pin, wherein the first detection pin is coupled to the ground circuit, and the second detection pin is coupled to the high voltage circuit; and
a metal sheet disposed in the shell;
(b) when the connector is not inserted into the shell of the connector detection device, the metal sheet of the connector detection device contacts the first detection pin and the second detection pin, the metal sheet, the first detection pin, and the second detection pin form a short circuit, so that the first detection pin and the second detection pin are both at the low voltage level, and the processing unit determines that the connector is not inserted into the shell based on both the first detection pin and the second detection pin being at the low voltage level; and
(c) when the connector is inserted into the shell, the connector presses the first detection pin and the second detection pin, and the metal sheet is separated from the first detection pin and the second detection pin, the metal sheet, the first detection pin, and the second detection pin form an open circuit, so that the first detection pin is at the low voltage level and the second detection pin is at the high voltage level, and the processing unit determines that the connector is inserted into the shell based on the first detection pin being at the low voltage level and the second detection pin being at the high voltage level.

8. The connector-related signal detection method according to claim 7, wherein, in step (b), the metal sheet further comprises a first and a second arm parts contacting the first detection pin and the second detection pin respectively.

9. The connector-related signal detection method according to claim 8, wherein, in step (c), the first and the second arm parts are respectively away from the first detection pin and the second detection pin.

10. The connector-related signal detection method according to claim 8, wherein, in step (b), each of the first and the second arm parts comprises a bending part respectively contacts the first detection pin and the second detection pin.

11. The connector-related signal detection method according to claim 10, wherein, in step (c), the bending part of the first and the second arm parts is respectively away from the first detection pin and the second detection pin.

12. The connector-related signal detection method according to claim 7, wherein step (c) further comprises: the connector presses a first protruding part of the first detection pin and a second protruding part of the second detection pin.
